# EUROPÄISCHE PATENTSCHRIFT

(11) **EP 1 918 101 B1**
(45) Veröffentlichungstag und Bekanntmachung des Hinweises auf die Patenterteilung: **07.11.2012**
(21) Anmeldenummer: 07016898.4
(22) Anmeldetag: 29.08.2007
(51) Int. Cl.: B41F 15/12, B41F 15/26, H01L 31/18, H01L 31/0224, H05K 3/12

(54) **Siebdruckanlage für Solarzellen mit Positioniereinrichtung**
Screen printing facility for solar cells comprising a positioning device
Installation de sérigraphie pour cellules solaires comprenant un dispositif de positionnement

(30) Priorität: 02.11.2006 DE 102006051558
(43) Veröffentlichungstag der Anmeldung: 07.05.2008
(73) Patentinhaber: Manz AG, 72768 Reutlingen (DE)
(72) Erfinder: Metzner, Klaus, 73266 Bissingen-Teck (DE); Manz, Dieter, 72667 Schlaitdorf (DE)
(74) Vertreter: Kohler Schmid Möbus

(56) Entgegenhaltungen:
- EP-A- 0 535 338
- EP-A- 0 535 399
- WO-A-2002/097534
- DE-A- 10 222 119
- DE-A- 10 345 576
- GB-A- 2 351 258
- US-A1- 2003 021 886
- US-A1- 2005 041 851

## Beschreibung

Die Erfindung betrifft eine Siebdruckanlage für die Solarzellenfertigung mit den Merkmalen des Oberbegriffs des Patentanspruchs 1.

Solarzellen aus Silizium werden für die rationelle industrielle Fertigung im Siebdruckverfahren metallisiert. Dazu wird auf der Vorderseite der Zelle eine Silberpaste zur Herstellung der Leiterbahnen aufgedruckt, die Zelle anschließend getrocknet und gewendet, bevor in einem zweiten Siebdruckvei-fahren die Rückseite mit Aluminium beschichtet und mit Leiterbahnen aus Silber versehen wird.

Dabei sind heute im Wesentlichen zwei Siebdruckverfahren im Einsatz.

Beim ersten Verfahren werden die Zellen beispielsweise auf einem Hubbalkensystem einer Siebdruckmaschine zugeführt, vom Hubbalkensystem mit einem Greifer auf einen linear angetriebenen Drucktisch oder einen Rundschalttisch abgesetzt und durch ein Kamerasystem auf ihre Lage kontrolliert. Die Lageinformation wird an die Druckeinheit der Siebdruckmaschine weitergeleitet und die Druckeinheit wird beim Einfahren des Tisches auf die Zelle ausgerichtet, bevor der Druckvorgang durchgeführt wird. Nach dem Druckvorgang fährt der Tisch aus dem Druckbereich heraus und die Zelle kann entnommen werden. Bei diesem Verfahren ist also die Ausrichtung der gesamten Druckeinheit auf die Zelle erforderlich. Dieser Vorgang ist zeit- und kostenintensiv. Außerdem kann mit einer Druckeinheit immer nur eine Zelle bedruckt werden.

Beim zweiten Verfahren werden die Zellen der Siebdruckmaschine über ein Riementransportsystem zugeführt, sodass die Zellen direkt auf den Drucktisch auffahren. Dort wird die Lage der Zelle optisch mithilfe von bis zu fünf Kameras erfasst und die Druckeinheit entsprechend der Lage der Zelle ausgerichtet, bevor der Druckvorgang ausgelöst wird. Danach wird die Zelle aus der Maschine heraustransportiert. Ein solches Verfahren ist beispielsweise in der DE 102 22 119 B4 beschrieben. Auch bei diesem Verfahren ist also eine Justierung der Druckeinheit auf die Zelle erforderlich.

Mit den beiden bekannten Verfahren können somit nur circa 1200 Zellen pro Stunde bedruckt werden.

Die GB 2 351 258 A beschreibt eine Anlage, in der ein zu bedruckendes Objekt auf zwei voneinander beabstandeten Transportbändern liegt und von diesen transportiert werden kann. Durch eine Erfassungseinrichtung wird die Lage des zu bedruckenden Objekts bezüglich eines Referenzobjekts erfasst. In einer Druckstation wird das zu bedruckende Objekt bezüglich des Referenzobjekts ausgerichtet und das Objekt anschließend bedruckt.

Aus der US 2005/0041851 A1 ist eine Siebdruckanlage bekannt, bei der ein zu bedruckendes Substrat mit einem Transportband unter eine Druckeinheit befördert und dort von einem Werkstückträger aufgenommen wird. Anschließend wird der Werkstückträger durch Verschieben in der X-Y-Ebene und durch Drehen um eine vertikale Achse bezüglich des Drucksiebs der Druckeinheit so ausgerichtet, dass beim Druckvorgang das gewünschte Druckbild auf dem Substrat entsteht. Anschließend wird der Werkstückträger weiter angehoben, das Werkstück mit einer Spannvorrichtung fixiert und der Druckvorgang ausgelöst. Nach dem Drucken wird die Spannvorrichtung geöffnet, der Werkstückträger wieder abgesenkt und das bedruckte Werkstück vom Transportband übernommen und aus der Siebdruckanlage herausbefördert. Bei dieser Anlage wird also nicht das Drucksieb justiert, sondern der Werkstückträger. Dazu ist es jedoch erforderlich, das Werkstück vom Transportband auf den Werkstückträger zu befördern, dort die Position des Werkstücks festzustellen und anschließend den Werkstückträger bezüglich des Drucksiebs auszurichten.

Aus der EP 0 535 338 A ist eine Siebdruckanlage bekannt, die ein Vakuum-Transportband aufweist, welches durch eine Reinigungseinrichtung führbar ist.

Die DE 103 45 576 A1 beschreibt eine Vorrichtung zum Löten von Solarzellen, bei der die Solarzellen auf ein endloses Transportband aufgelegt und vor Einlauf in die Lötstation vorgewärmt werden. Das Transportband ist als Vakuumsband ausgeführt. Weiter wird eine Lageveränderung des Transportbands durch Erwärmung überwacht.

Der vorliegenden Erfindung liegt die Aufgabe zugrunde, eine Siebdruckanlage zu schaffen, mit der wesentlich mehr Zellen pro Stunde zuverlässig bedruckt werden können als mit den bekannten Anlagen.

Die Aufgabe wird mit einer Siebdruckanlage mit den Merkmalen des Patentanspruchs 1 gelöst.

Bei der neuen Siebdruckanlage wird also keine zeitintensive Ausrichtung der Druckeinheit auf die Zellen durchgeführt. Stattdessen werden die Solarzellen bereits lagegenau, d. h. auf das Drucksieb ausgerichtet, auf dem Transportband positioniert. Während des Druckvorgangs verbleiben sie auf dem Transportband in dieser festgelegten Position. Dadurch können mehr Solarzellen pro Stunde bedruckt werden als mit den herkömmlichen Siebdruckmaschinen.

Vorzugsweise kann dabei die Positioniereinrichtung die Solarzellen von einer Zuführeinrichtung übernehmen, ihre Lage in der Positioniereinrichtung erfassen und sie gemäß bereits während des Layouts der Solarzellenstruktur generierten Positionierdaten ausrichten und auf dem Transportband absetzen. Bereits vor Aufnahme der Solarzellen durch die Positioniereinrichtung liegt also deren Soll-Position auf dem Transportband fest. Die Positioniereinrichtung erfasst erst nach Aufnahme der Solarzellen deren Lage innerhalb der Positioniereinrichtung und kann so entsprechend der festgestellten Ist-Position die Solarzellen in der gewünschten Soll-Position auf das Transportband bringen.

Weitere Vorteile ergeben sich dabei, wenn die Positioniereinrichtung eine Greifvorrichtung mit einer integrierten optischen Aufnahmeeinrichtung aufweist, ... die nach dem Ergreifen der Solarzelle und/oder während deren Bewegung durch den Greifer Aufnahmen von der Solarzelle macht, diese an eine Steuereinheit weiterleitet, die die Bildinformation auswertet und die Greifvorrichtung in Abhängigkeit von der Bildinformation ansteuert. Bei dieser Ausgestaltung der Positioniereinrichtung erfolgt die Lageerfassung der Solarzelle während der Bewegung des Greifers, sodass dafür keine zusätzliche Zeit benötigt wird. Mit der Aufnahmeeinrichtung kann außerdem zur gleichen Zeit eine Kontrolle der Zelle auf mechanische Beschädigungen durchgeführt werden.

Der Greifer kann ein Vakuum-Greifer oder ein Bernoulli-Greifer sein, mit denen Solarzellen unterschiedlichen Formats ohne mechanische Eingriffe am Greifer manipuliert werden können.

Die Positionierdaten für die Solarzelle, die während des Layouts der Solarzellenstruktur generiert werden können und die die Soll-Position der Solarzelle auf dem Transportband bestimmen, können vorzugsweise die X- und Y-Koordinaten des Mittelpunkts und mindestens eines weiteren Punkts der Solarzelle sein. Durch diese Koordinaten ist die Lage der Solarzelle eindeutig bestimmt.

Mit der erfindungsgemäßen Siebdruckanlage lassen sich auch mehrere Solarzellen zum gleichzeitigen Bedrucken auf dem Transportband positionieren. Die Anzahl der Solarzellen hängt von deren Format sowie von der Größe der Druckeinheit ab. Durch das gleichzeitige Bedrucken mehrerer Zellen lässt sich der Durchsatz der Anlage vervielfachen.

Weitere Vorteile ergeben sich, wenn das Transportband ein Vakuumband ist. Dadurch können die Solarzellen ohne mechanische Spanneneinrichtungen, die die Zellen beschädigen könnten, sicher auf dem Transportband gehalten werden. Das Vakuumband kann außerdem derart gestaltet werden, dass Solarzellen unterschiedlicher Formate ohne mechanische Änderungen am Vakuumband transportiert und fixiert werden können. Die Siebdruckanlage lässt sich dadurch rasch auf Solarzellen anderer Formate umstellen.

Das Transportband kann vorzugsweise auch als Endlosband ausgestaltet sein und unterhalb des Stütztisches eine Reinigungseinrichtung durchlaufen, die eventuell auf der Oberfläche des Bandes vorhandene Verschmutzungen automatisch entfernt. Solche Verschmutzungen kommen insbesondere dann vor, wenn Solarzellen beim Druck brechen und dadurch Leiterpaste auf die Oberfläche des Transportbandes gelangt. Bisher wird in diesen Fällen der Drucktisch entweder von Hand gereinigt, oder es wird auf den Drucktisch ein Vlies aufgebracht, das nach jedem Druckvorgang weitertransportiert wird, sodass der Druckbereich sauber bleibt. Demgegenüber muss bei Vorsehen eines Endlos-Transportbandes mit glatter Oberfläche, das eine Reinigungsanlage durchläuft, kein zusätzliches Material auf das Transportband aufgebracht oder dieses gar von Hand gereinigt werden, was jedes Mal eine Unterbrechung der Produktion bedeutet.

Die Reinigungsanlage kann vorzugsweise mindestens eine Schneckenbürste aufweisen, die zumindest die äußere Oberfläche des Transportbandes mithilfe eines Reinigungsmediums reinigt. Überschüssiges Reinigungsmedium kann durch nach der mindestens einen Streifenbürste angeordnete Abstreifer wieder entfernt werden. Außerdem kann eine Trocknungseinrichtung, beispielsweise in Form eines Luftmessers, vorgesehen sein.

Die Druckeinheit der erfindungsgemäßen Siebdruckanlage kann sowohl eine Flachsiebdruckeinheit als auch eine Rotationssiebdruckeinheit sein. Beim Flachdruck wird das Transportband getaktet vorgeschoben, während bei Rotationsdruck ein kontinuierlicher Vorschub des Transportbandes möglich ist. Die Verwendung einer Rotationsdruckeinheit ermöglicht daher eine noch weitere Steigerung des Durchsatzes der Siebdruckanlage. Die Druckeinheit kann beim Druckvorgang auf das Transportband zubewegbar sein. Bei einer bevorzugten Ausgestaltung allerdings weist die Druckeinheit während des Transportvorgangs der Solarzellen und während des Druckvorgangs den gleichen Abstand zum Stütztisch auf. Damit kann auch eine Hubbewegung der Druckeinheit entfallen oder allenfalls zu Reinigungs- und Austauschzwecken durchgeführt werden. Durch das Entfallen der Hubbewegung der Druckeinheit lässt sich der Druckvorgang weiter beschleunigen. Die Verformung des Siebes durch die Rakel reicht aus, das Material auf die Solarzellen aufzutragen. Springt das Sieb wieder zurück, können die Solarzellen weiterbefördert werden.

Nachfolgend wird eine bevorzugte Ausführungsform einer erfindungsgemäßen Siebdruckanlage anhand der Zeichnung näher beschrieben.

Es zeigen:
- Fig. 1: eine schematische Seitenansicht einer Siebdruckanlage;
- Fig. 2: eine Draufsicht auf die Reinigungsanlage der Siebdruckanlage aus Fig. 1.

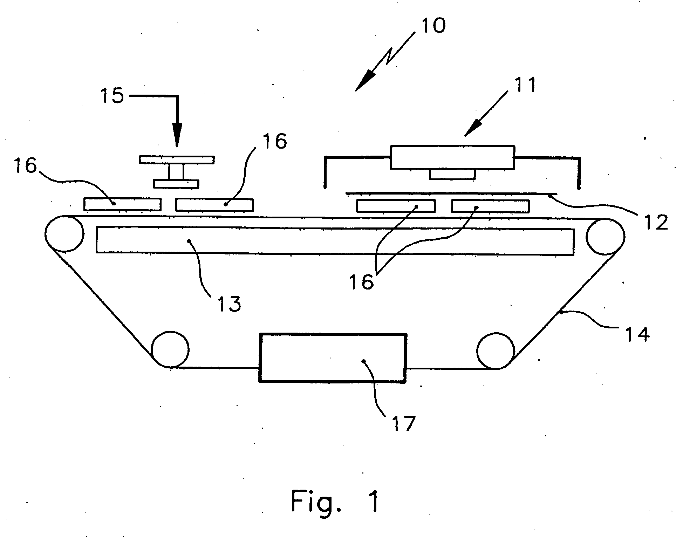

Fig. 1 zeigt eine schematische Seitenansicht einer Siebdruckanlage 10 mit einer Druckeinheit 11, die einen Drucksieb 12 aufweist. Unterhalb der Druckeinheit 11 ist ein Stütztisch 13 angeordnet, über den ein Transportband 14 hinweg bewegbar ist und der sich bis unterhalb einer Positioniereinrichtung 15 erstreckt, die im dargestellten Beispiel zwei Solarzellen 16 lagegenau auf dem Transportband 14 positioniert, sodass die Solarzellen 16 exakt bezüglich des Drucksiebs 12 ausgerichtet sind. Dadurch kann eine Verstelleinrichtung für die Druckeinheit 11 entfallen. Einmal auf das Transportband 14 abgesetzt, verbleiben die Solarzellen 16 während des gesamten Druckvorgangs dort. Der Stütztisch 13 stabilisiert dabei das Transportband 14 mechanisch.

Die Positioniereinrichtung 15 kann, was hier nicht dargestellt ist, mindestens eine optische Aufnahmeeinrichtung aufweisen, mit der die Position der aufgenommenen Solarzellen exakt bestimmt werden kann. Während der Bewegung der Solarzelle 16 auf das Transportband 14 zu, kann dann die Positioniereinrichtung 15 mit Hilfe der gewonnenen Bildinformation und den vorliegenden Daten über die Soll-Position der Solarzellen 16 auf dem Transportband 14 diese exakt auf dem Transportband 14 positionieren.

Das Transportband 14 ist als Endlosband ausgeführt, vorzugsweise als Vakuumband aus Edelstahl, wobei die Vakuumzuführung im Stütztisch 13 integriert sein kann. Durch die Vakuumansaugung können die Solarzellen 16 ohne Anschläge oder Spanneneinrichtungen, die zu Beschädigungen der Solarzellen 16 führen könnten, auf dem Transportband 14 auch während des Druckvorgangs festgehalten werden. Die Edelstahloberfläche hat außerdem den Vorteil, dass sie leicht zu reinigen ist. Hierzu ist unterhalb des Stütztisches 13 eine Reinigungseinrichtung 17 vorgesehen, die vom Transportband 14 durchlaufen wird. Dadurch findet eine stetige automatische Reinigung des Bandes 14 statt. Die Druckeinheit 11 hat vorzugsweise einen konstanten Abstand zum Stütztisch 13, der ausreichend ist, die Solarzellen 16 bei nicht durch eine Rakel (nicht gezeigt) beaufschlagtes Drucksieb 12 widerstandsfrei unter der Druckeinheit hindurch zu bewegen. Während des Druckvorgangs wird das Drucksieb 12 durch die Rakel gegen die Solarzellen 16 gedrückt. Die Druckeinheit 11 kann somit als feststehende Einheit ausgebildet werden. Die Entnahme des Drucksiebs 12 zu Reinigungs- oder Austauschzwecken kann seitlich erfolgen. Selbstverständlich ist es jedoch auch möglich, die Druckeinheit 11 mit einer Hubeinrichtung auszustatten.

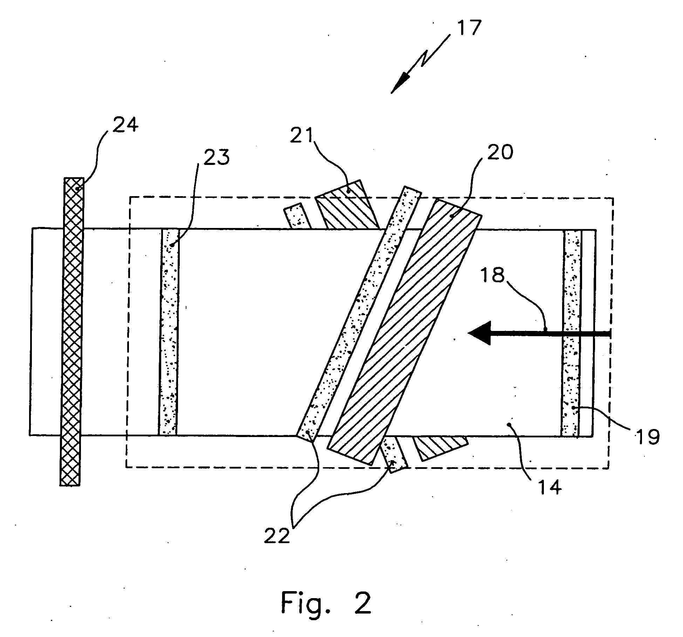

Fig. 2 zeigt einen möglichen Aufbau der Reinigungseinrichtung 17. Das Transportband 14 durchläuft die Anlage 17 in Pfeilrichtung 18. Dabei passiert das Transportband 14 zunächst eine Dichtlippe 19. Anschließend werden die obere und untere Oberfläche des Transportbandes 14 durch zwei rotierende und mit Reinigungsmedium versehene Schneckenbürsten 20 und 21 gereinigt. Überschüssiges Reinigungsmedium wird durch den Schneckenbürsten 20, 21 nachgeordnete Abstreifer 22 wieder entfernt. Anschließend passiert das Transportband 14 eine zweite Dichtlippe 23 und wird dann durch ein Luftmesser 24 getrocknet.

## Patentansprüche

1. Siebdruckanlage für die Solarzellenfertigung mit einer Druckeinheit (11), einem Transportband (14), einem Stütztisch (13) für das Transportband (14) und einer Positioniereinrichtung (15), **dadurch gekennzeichnet, dass** der Stütztisch (13) für das Transportband (14), das über den Stütztisch (13) hinweg bewegbar ist, unterhalb der Druckeinheit (11) angeordnet ist und die Positioniereinrichtung (15) geeignet ist, die Solarzellen (16) zur Druckeinheit (11) exakt ausgerichtet auf dem Transportband (14) zu positionieren.

2. Siebdruckanlage nach Anspruch 1, **dadurch gekennzeichnet, dass** die Positioniereinrichtung (15) die Solarzellen (16) von einer Zuführeinrichtung übernimmt, ihre Lage in der Positioniereinrichtung (15) erfasst und entsprechend während des Layouts der Solarzellenstruktur generierten Positionierdaten die Solarzellen (16) ausrichtet und auf dem Transportband (14) absetzt.

3. Siebdruckanlage nach Anspruch 2, **dadurch gekennzeichnet, dass** die Positionierdaten X- und Y-Koordinaten des Mittelpunkts und mindestens eines weiteren Punkts der Solarzellen (16) sind.

4. Siebdruckanlage nach Anspruch 2 oder 3, **dadurch gekennzeichnet, dass** die Positioniereinrichtung (15) eine Greifvorrichtung mit einer integrierten optischen Aufnahmeeinrichtung aufweist, die nach dem Ergreifen der Solarzelle (16) und/oder während deren Bewegung durch den Greifer Aufnahmen von der Solarzelle macht, diese an eine Steuereinheit weiterleitet, die die Bildinformation auswertet und die Greifvorrichtung in Abhängigkeit von der Bildinformation ansteuert.

5. Siebdruckanlage nach einem der Ansprüche 1 bis 4, **dadurch gekennzeichnet, dass** mehrere Solarzellen (16) zum gleichzeitigen Bedrucken auf dem Transportband (14) positionierbar sind.

6. Siebdruckanlage nach einem der Ansprüche 1 bis 5, **dadurch gekennzeichnet, dass** das Transportband (14) ein Vakuumband ist.

7. Siebdruckanlage nach einem der Ansprüche 1 bis 6, **dadurch gekennzeichnet, dass** das Transportband (14) als Endlosband ausgestaltet ist und unterhalb des Stütztisches (13) eine Reinigungseinrichtung (17) durchläuft.

8. Siebdruckanlage nach einem der Ansprüche 1 bis 7, **dadurch gekennzeichnet, dass** ihr eine optische Kontrolleinheit nachgeschaltet ist, die die Lage des Druckbilds auf der Solarzelle (16) erfasst und bei Abweichungen von der gewünschten Lage Korrektursignale an die Positioniereinrichtung (15) weiterleitet.

9. Siebdruckanlage nach einem der Ansprüche 1 bis 8, **dadurch gekennzeichnet, dass** die Druckeinheit (11) eine Flachsiebdruckeinheit ist.

10. Siebdruckanlage nach einem der Ansprüche 1 bis 8, **dadurch gekennzeichnet, dass** die Druckeinheit (11) eine Rotationssiebdruckeinheit ist.

11. Siebdruckanlage nach einem der Ansprüche 1 bis 10, **dadurch gekennzeichnet, dass** die Druckeinheit (11) während des Transportvorgangs der Solarzellen und während des Druckvorgangs den gleichen Abstand zum Stütztisch (13) aufweist.

## Claims

1. A screen printing system for manufacturing solar cells, comprising a printing unit (11), a conveyor belt (14), a supporting table (13) for the conveyor belt (14) and a positioning device (15), **characterized in that** the supporting table (13) for the conveyor belt (14), which moves over the top of the supporting table (13), is placed underneath the printing unit (11), and the positioning device (15) is suitable for positioning the solar cells (16) on the conveyor belt (14) in such a way that they are precisely aligned relative to the printing unit (11).

2. A screen printing system according to Claim 1, **characterized in that** the positioning device (15) receives the solar cells (16) from a feeder device, determines their position in the positioning device (15) and, according to positioning data generated during the layout of the solar cell structure, orients the solar cells (16) and sets them down on the conveyor belt (14).

3. A screen printing system according to Claim 2, **characterized in that** the positioning data are X and Y coordinates of the mid-point and of at least one additional point of the solar cells (16).

4. A screen printing system according to Claim 2 or 3, **characterized in that** the positioning device (15) has a gripping device with an integrated optical camera, which takes photographs of the solar cell after the solar cell (16) has been seized and/or as it is being moved by the gripper, and transfers said photographs to a control unit, which evaluates the image information and controls the gripping device as a function of said image information.

5. A screen printing system according to one of Claims 1 to 4, **characterized in that** a number of solar cells (16) can be positioned on the conveyor belt (14) for simultaneous printing.

6. A screen printing system according to one of Claims 1 to 5, **characterized in that** the conveyor belt (14) is a vacuum belt.

7. A screen printing system according to one of Claims 1 to 6, **characterized in that** the conveyor belt (14) is formed as an endless belt and passes through a cleaning device (17) located underneath the supporting table (13).

8. A screen printing system according to one of Claims 1 to 7, **characterized in that**, connected downstream of said system, there is an optical control unit which detects the position of the printed image on the solar cell (16) and in the event of deviations from the desired position transmits correcting signals to the positioning device (15).

9. A screen printing system according to one of Claims 1 to 8, **characterized in that** the printing unit (11) is a flat screen printing unit.

10. A screen printing system according to one of Claims 1 to 8, **characterized in that** the printing unit (11) is a rotary screen printing unit.

11. A screen printing system according to one of Claims 1 to 10, **characterized in that**, during the process of conveying the solar cells and during the printing process, the printing unit (11) remains at a constant distance from the supporting table (13).

## Revendications

1. Installation de sérigraphie pour la fabrication de piles solaires avec une unité d'impression (11), une bande transporteuse (14), une table d'appui (13) pour la bande transporteuse (14) et un dispositif de positionnement (15), **caractérisée en ce que** la table d'appui (13) pour la bande transporteuse (14), qui peut être déplacée au-dessus de la table d'appui (13), est aménagée en dessous de l'unité d'impression (11) et le dispositif de positionnement (15) convient pour positionner les piles solaires (16) sur la bande transporteuse (14) dans l'alignement exact avec l'unité d'impression (11).

2. Installation de sérigraphie selon la revendication 1, **caractérisée en ce que** le dispositif de positionnement (15) prend en charge les piles solaires (16) d'un dispositif d'alimentation, détermine leur position dans le dispositif de positionnement (15) et, en fonction de données de position générées au cours de la mise en place de la structure de piles solaires, aligne les piles solaires (16) et les dépose sur la bande transporteuse (14).

3. Installation de sérigraphie selon la revendication 2, **caractérisée en ce que** les données de position sont des coordonnées X et Y du point central et d'au moins un autre point des piles solaires (16).

4. Installation de sérigraphie selon la revendication 2 ou la revendication 3, **caractérisée en ce que** le dispositif de positionnement (15) présente un dispositif de préhension avec un dispositif récepteur optique intégré, qui effectue la réception de la pile solaire après préhension de la pile solaire (16) et/ou son déplacement par le dispositif de préhension, l'achemine à une unité de commande, qui exploite les informations d'image et commande le dispositif de préhension en fonction des informations d'image.

5. Installation de sérigraphie selon l'une quelconque des revendications 1 à 4, **caractérisée en ce que** plusieurs piles solaires (16) peuvent être positionnées pour une impression simultanée sur la bande transporteuse (14).

6. Installation de sérigraphie selon l'une quelconque des revendications 1 à 5, **caractérisée en ce que** la bande transporteuse (14) est une bande sous vide.

7. Installation de sérigraphie selon l'une quelconque des revendications 1 à 6, **caractérisée en ce que** la bande transporteuse (14) se présente sous la forme d'une bande sans fin et parcourt un dispositif de nettoyage (17) en dessous de la table d'appui (13).

8. Installation de sérigraphie selon l'une quelconque des revendications 1 à 7, **caractérisée en ce qu'**il lui est connecté en aval une unité de contrôle optique qui détermine la position de l'image d'impression sur la pile solaire (16) et, lors d'écarts avec la position souhaitée, transmet des signaux de correction au dispositif de positionnement (15).

9. Installation de sérigraphie selon l'une quelconque des revendications 1 à 8, **caractérisée en ce que** l'unité d'impression (11) est une unité d'impression sérigraphique à plat.

10. Installation de sérigraphie selon l'une quelconque des revendications 1 à 8, **caractérisée en ce que** l'unité d'impression (11) est une unité d'impression sérigraphique à rotation.

11. Installation de sérigraphie selon l'une quelconque des revendications 1 à 10, **caractérisée en ce que** l'unité d'impression (11) présente la même distance à la table d'appui (13) pendant l'opération de transport des piles solaires et pendant l'opération d'impression.
